## Europäisches Patentamt

## European Patent Office

## Office européen des brevets

(11) Publication number: **0 017 144**
**B1**

(12) **EUROPEAN PATENT SPECIFICATION**

(45) Date of publication of patent specification: **16.07.86**

(51) Int. Cl.⁴: **G 03 B 41/00**

(21) Application number: **80101576.9**

(22) Date of filing: **25.03.80**

(86) International application number:
**PCT/ 25/ 146**

(54) **An apparatus for precisely moving a table.**

(30) Priority: **06.04.79 JP 41108/79**

(43) Date of publication of application:
**15.10.80 Bulletin 80/21**

(45) Publication of the grant of the patent:
**16.07.86 Bulletin 86/29**

(84) Designated Contracting States:
**DE FR GB NL**

(56) References cited:
**US-A-3 188 910**
**US-A-3 790 266**

**THE BELL SYSTEM TECHNICAL JOURNAL, vol.
49, no. 9, November 1970, pages 2145-2177,
Murray Hill, New Jersey, D.S. ALLES et al.:
"The step and repeat camera"**

(73) Proprietor: **Hitachi, Ltd.**
**5-1, Marunouchi 1-chome**
**Chiyoda-ku Tokyo 100 (JP)**

(72) Inventor: **Moriyama, Shigeo**
**2-32, Koyasu-cho**
**Hachioji-shi Tokyo (JP)**
Inventor: **Ito, Masaaki**
**3-1-2, Higashi-koigakubo**
**Kokubunji-shi Tokyo (JP)**
Inventor: **Harada, Tatsuo**
**2-59-22, Shinmachi**
**Fuchu-shi Tokyo (JP)**

(74) Representative: **Strehl, Peter, Dipl.-Ing. et al**
**Strehl, Schübel-Hopf, Schulz Patentanwälte**
**Widenmayerstrasse 17 Postfach 22 03 45**
**D-8000 München 22 (DE)**

# Description

This invention relates to an apparatus for precisely moving a table according to the introductory portion of claim 1 or 2, the apparatus being used in a step-and-repeat camera, a step-and-repeat projection printing apparatus, etc.

The apparatus of step-and-repeat cameras etc. as above mentioned project and print photographically an integrated circuit pattern on a mask substrate or wafer which is usually coated with photoresist. On account of the restriction of the image area of a projection lens, however, it is impossible to print the whole area of the aforecited mask substrate or wafer at a stroke. Therefore, in such apparatus, a precisely movable X—Y table is provided, the mask substrate or wafer is installed thereon, and, while intermittently driving the table in the X- and Y-directions, the integrated circuit pattern is arrayed and printed on the entire area of the mask substrate or wafer.

In the production of an integrated circuit, it is required that circuit patterns differing from one another be overlapped on a single wafer, at a positioning precision of approximately 0.2 μm, ordinarily 8 to 12 times or so. For this reason, the drive and movement of the X—Y movable table has to occur with an equal or higher positioning precision. Further, such X—Y movable table is required to execute high-speed positioning in order to enhance the productivity.

Therefore, in many conventional X—Y movable tables, a Y-directional movable table is stacked on an X-directional movable table and a driving system for the Y-directional movement including a motor, feed screws etc. is installed on the X-directional movable table. Although this structure attains a comparatively excellent machine precision, the masses of the movable parts inevitably become great and the high-speed positioning as above mentioned is impossible.

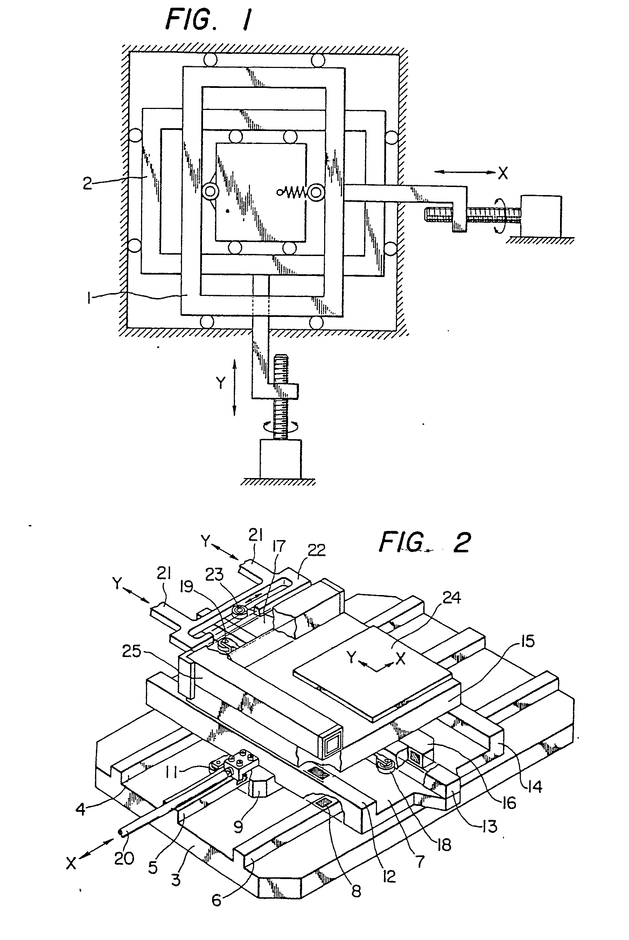

As an improvement on such prior-art apparatus, an X—Y movable table has been known, as shown in Fig. 1, wherein both X- and Y-driving systems are fixed to a rest frame (refer to "Kikai Sekkei (Machine Design)", vol. 14, No. 2, 1970, page 35). With this structure, however, in case where the movable table moves in the Y-axial direction, guide surfaces are both, the surfaces of an X-frame portion 1 and a Y-frame portion 2, so that the straightness of the moving direction is liable to be spoilt disadvantageously. In addition, there are many rolling guide surfaces whose members are required to be hard, and long periods of time for working and for assemblage and adjustment are required in order to achieve a high precision of the movable table. In such prior-art apparatus, the problems can be considerably reduced by replacing the rolling guide by a sliding guide which employs a high polymer material for sliders. More specifically, since the sliding guide does not require the hardness of guide surfaces, the working of the parts is facilitated, and since the contact areas between the sliders and the guide surfaces can be made large, minute form errors of the guide surfaces are averaged, so that the sliding guide is capable of movements of higher precision as compared with the rolling guide. Further, since appropriate sliding frictions are exhibited because of the sliding guide, the settling property after the positioning can be made much faster than in the case of the rolling guide.

However, even when such sliding guide is applied, the X—Y two-dimensional movable table as stated above incurs another disadvantage in contrast to the aforecited advantages. That is, strain energy which corresponds to the parellelism error between both the guide surfaces of the X-frame portion 1 and the Y-frame portion 2 in Fig. 1 is accumulated in the frame members etc., and this brings about such disadvantage that the yaw or the stick slip is caused. This is attributed to the frictional forces of the sliding parts. A further disadvantage is that the strain energy is gradually released to give rise to a phenomenon in which the movable table drifts at a very low speed of, for example, 0.1 to 0.5 μm/sec after the positioning thereof.

From The Bell System Technical Journal, vol. 49, No. 9, November 1970, pages 2145 to 2177, a stage drive for a step-and-repeat camera is known which comprises a movable member and rectilinear drive means respectively disposed and fixed on X- and Y-coordinate axes. The movable member is constructed of an X-axial movable intermediate member named "cross" and the Y-axial movable stage itself. The movement of the cross is constrained to the X-direction by two colinear quartz guide blocks. The stage is also guided by a pair of quartz guide blocks mounted on the top surface of the cross in parallel to the Y-axis. Stage and cross are driven by drive systems with low backlash resulting inevitably from the use of movable mechanical members and air bearings. While the X-axis drive is attached to the cross through a slender flexible column which allows both, vertical and horizontal misalignment between the cross and the drive, the Y-axis drive is coupled directly to the stage through two air bearings and a guide bar attached to the stage.

The object of the present invention is to provide an apparatus for precisely moving a table, which permits high-speed positioning and high-precision movement of the movable table.

This object is solved by an apparatus according to claim 1 or 2, which apparatus comprises a movable member constructed of an X-axial movable table and a Y-axial movable table, which tables are driven by respective rectilinear drive means and are coupled thereto by coupling means. According the characterizing portion of claim 1, said coupling means comprises a roller portion whose rotary shaft is fastened to a part of said Y-axial movable table and which serves for the Y-axial drive, and a member having an oblong opening extending in the X-axial direction, whose width is greater than the outside diameter of said roller portion. According to the characterizing portion of claim 2, the coupling means is constructed of two rollers whose respective rotary shafts are fastened to a part of said Y-axial movable table, and a rod which extends in the X-axial direction and which is held between said two rollers with a backlash.

Due to this structure, when the movable member and the rectilinear drive means are coupled in the X- or Y-axial direction, they are released in the respective other direction. This results from the defined backlash which is provided between the driving frame and the roller portion in order to allow the movement of the Y-axial movable table also in the X-axial direction at high precision.

Preferred embodiments of the invention are described with reference to the attached drawings wherein

Fig. 1 is a view for explaining a prior-art X—Y movable table,

Fig. 2 is a view for explaining an apparatus for precisely moving a table according to an embodiment of this invention,

Fig. 3 is a diagram for explaining a Y-axial control in the apparatus,

Fig. 4 is a view for explaining another embodiment of this invention, and

Fig. 5 is a view showing an example of a load relieving mechanism.

Hereunder, the invention will be described in detail with reference to embodiments.

Figure 2 is a schematic perspective view showing an embodiment of this invention. In the figure, three guide rails 4, 5 and 6 for an X-axis are provided on a base 3, and an X-axis movable table 7 slides with its load carried by the guide rails 4 and 6. In four places of the lower surface of the X-axis movable table 7, sheets 8 made of a high polyer material (for example, sliders made of ethylene tetrafluoride polymer or the like) are bonded to reduce the frictional resistance. Two yaw sliders 9 one of which does not appear in the figure) are disposed in the middle parts of the X-axis movable table 7, and are pushed against a side surface of the guide rail 5 by rollers 11 which are urged by leaf springs in advance. That is, the X-axis movable table 7 carries out a rectilinear motion along this guide rail 5.

Similarly, guide rails 12, 13 and 14 for a Y-axis are provided on the X-axis movable table 7, and a Y-axis movable table 15 for placing a workpiece or the like thereon carries out a rectilinear motion in the Y-axial direction in such a manner that the guide rail 13 is held between yaw sliders 16 and 17 and rollers 18 and 19. The rectilinear motion of a driving system which is not shown and which is made up of a combination of a D.C. servomotor, ball screws etc. is transmitted to the movable tables 7 and 15 through respective connecting rods (driving rods) 20 and 21 for the X- and Y-axes. The fore end part of the Y-axial connecting rod assembly 21 is provided with a driving frame 22 having an oblong opening, within which a roller portion (for example, bearing) 23 is constrained. Since a rotary shaft of the roller portion 23 is fixed onto the yaw slider 17, the motion of the connecting rod assembly 21 is transmitted to the Y-axial movable table 15.

The width of the oblong opening of the driving frame 22 is greater than the outside diameter of the roller portion 23, in other words, a backlash is provided between both the parts. Therefore, the Y-axial movable table 15 is guided by only the X-axial guide rail 5 without being restrained by the driving frame 22 and can be moved also in the X-axial direction at high precision without causing a yaw or spoiling the rectilinearity.

In case of moving the Y-axial movable table 15 in the Y-axial direction, the roller portion 23 is driven in contact with the driving frame 22. Therefore, a control for providing the backlash is made after the Y-axial positioning. The details will be described later.

In Figure 2, a part 24 on the Y-axial movable table 15 is a workpiece (for example, glass substrate), and a part 25 is a reflector for a laser interference measuring instrument (not shown) which detects the position of the Y-axial movable table 15. In the present embodiment, the position control is carried out by a closed loop control which employs the laser interference measuring instrument as a position sensor. The position control with respect to the X-axis is the conventional linear position control, whereas in case of the Y-axis, the ordinary closed loop control incurs hunting and cannot achieve a good positioning accuracy on account of the existence of the backlash.

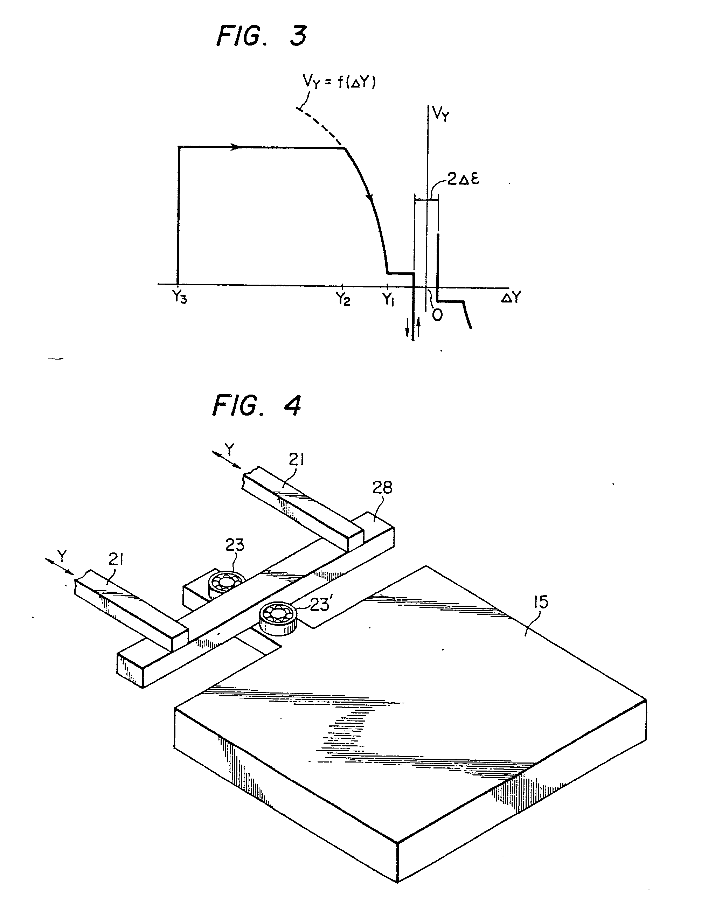

Figure 3 is a diagram for explaining the Y-axial control. In the figure, the axis of abscisses represents the positional deviation $\Delta Y$ from a desired position O, while the axis of the ordinate represents the velocity command $V_Y$ for the D.C. servomotor. By way of example, in case of precisely moving the workpiece 10 mm, when a start instruction is given to the position control system, the D.C. servomotor is commanded to rotate at the maximum speed. In the present embodiment, 50 mm/s, for example, is the maximum speed. Until the Y-axial movable table having started from a position $Y_3$ reaches a position $Y_2$, it moves at the maximum speed. Beyond the position $Y_2$, the velocity command is changed-over to a curve $V_y=f(\Delta Y)$, and the Y-axial movable table is smoothly decelerated. Further, when a position $Y_1$ is reached, the velocity command becomes a constant speed again, and the Y-axial movable table approaches the desired position at the speed of, for example, 1 mm/s or so. When a position of $\pm\Delta\varepsilon$ before or behind the desired position is reached, a reverse command is applied to the D.C. servomotor for, e.g., about 5 ms, and the driving frame 22 is retreated to prepare the backlash.

In the present embodiment, by way of example, the positions $Y_2$ and $Y_1$ are respectively set at 250 μm and 25 μm, and the deceleration curve is made $V_y=f(\Delta Y)=3.3$ $\sqrt{|\Delta Y+25|}+1.0$ (where the unit of $\Delta Y$ is μm, and the unit of $f(\Delta Y)$ is mm/s). $\Delta\varepsilon$

is set at 2 μm, and the amount of the backlash is set at 60 μm. These various parameters are determined by the masses of the movable parts, the frictional resistances of the sliding parts, the response characteristic of the D.C. servomotor, etc.

With the above embodiment, a straighness of ±1 μm and a yaw of ±3×10⁻⁶ radian have been obtained for a moving range of 150×150 mm. This has been accomplished because, in accordance with the present invention, no excessive force or moment acts on the Y-axial movable table. Regarding the positioning time, in case of the movement of 10 mm by way of example, it was possible to position and set the Y-axial movable table within ±2 μm of the desired position in approximately 300 ms. This is also based on the fact that the present invention has made it possible to introduce the sliding guide which is excellent in the settling property. This invention is not restricted to the deceleration curve $(V_Y)$ illustrated in the concrete example, but deceleration curves can be appropriately selected and applied depending upon set conditions etc.

The foregoing example of Figure 2 may well be replaced by a construction as shown in Figure 4. More specifically, a rod 28 extending in the X-axial direction is disposed instead of the driving frame 22 at the fore ends of the Y-axial connecting rods 21, two rollers 23 and 23' have their respective rotary shafts fixed to a part of the Y-axial movable table 15, and the rod 28 is held between the rollers 23 and 23' with a backlash. Also in this case, the same effects as in the example of Figure 2 are attained.

In case where the sliding guide employing high polymer material or the like for the sliders is adopted as in the foregoing embodiment, there are the advantages as stated above, but the sliders of high polymer material sometimes wear of to change the degree of orthogonality of the X- and Y-axes. In addition, the coefficient of friction of the sliding portion is comparatively great (for example, approximately 0.2), so that the frictional force against the movement becomes great degrading thereby the positioning precision. In order to eliminate such problems, a mechanism to be stated below is suited.

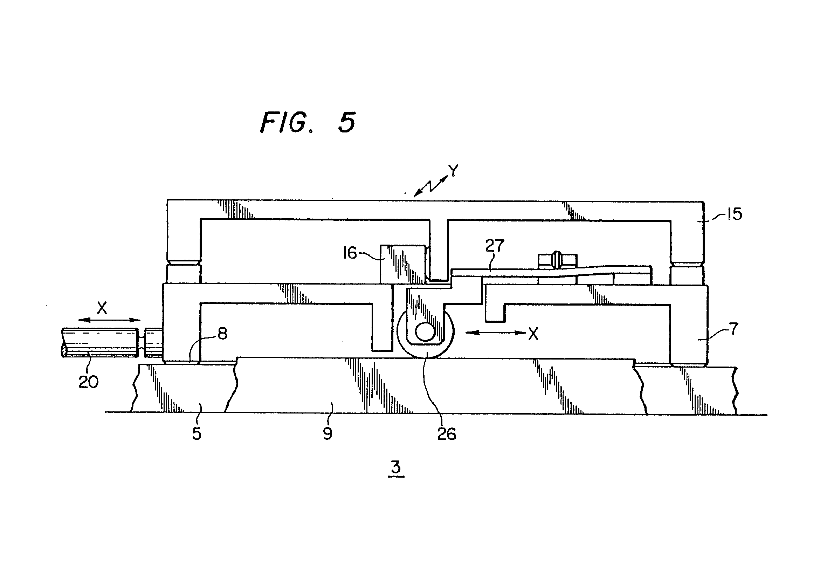

Figure 5 is a view for explaining an example of the mechanism for eliminating the problems, and shows a section parallel to the X-axis. The feature of this example consists in a weight lightening mechanism for the X-axial movable table 7 as is made up of a load relieving roller 26 and a spring 27 (for example made of a phosphor bronze plate). More specifically, the load relieving roller 26 is previously loaded in the gravitational direction by means of the spring 27 which has its fixed end on the X-axial movable table 7, and it is placed on the X-axial yaw guide 9 to relieve the load of the X-axial movable table 7 to the amount of the loaded component. Since the position of the load relieving roller 26 is substantially the central part of the X-axial movable table 7 and coincident with the centroid thereof, loads which act on the four sliders 8 on the lower surface of the X-axial movable table are uniformly relieved. By conjointly employing the rolling guide in this manner, it is possible to reduce the quantities of wear of the respective sliders made of the high polymer material and to lessen the frictional force in the moving direction.

As set forth above even in the X—Y movement mechanism in which the driving system for both the X- and Y-axes is fixed to the rest frame, neither the X-axial movable table nor the Y-axial movable table undergoes any unreasonable force or moment, and excellent rectilinearity and yaw characteristics can be attained. Further, since no excessive force or moment acts as stated above, the sliding guides which are excellent in the settling property can be used as the guides in the X- and Y-axial directions, and it is possible to render the speed of the positioning high. Although this invention can bring forth the greatest effect in case of employing the sliding guide as the guide of the movable table, it is not restricted thereto but is also applicable to cases of the rolling guide, the pneumatic bearing guide, etc. This invention is not restricted to concrete numerical values, the materials etc. used in the foregoing embodiments, but they can be appropriately selected and applied depending upon set conditions etc.

In this manner, the present invention is greatly effective when applied to workpiece moving tables of high speed and high precision, etc., which are used in semiconductor producing equipment such as step-and-repeat cameras and step-and-repeat projection printing apparatuses, and other precision type measuring instruments and precision machines.

The foregoing embodiments have been described for the case where the movable members move rectilinearly in two directions intersecting orthogonally, such as the X- and Y-axial directions. However, this invention is not restricted thereto but is of course applicable to a case where movable members move rectilinearly in two directions defining a certain angle other than 90 degrees therebetween.

**Claims**

1. An apparatus for precisely moving a table comprising rectilinear drive means respectively disposed and fixed on X- and Y-coordinate axes,

a movable member constructed of an X-axial movable table (7) and a Y-axial movable table (15), which tables are driven by the respective rectilinear drive means, and

coupling means to couple said movable tables (7; 15) and said rectilinear drive means, characterized in that

said coupling means comprises a roller portion (23) whose rotary shaft is fastened to a part of said Y-axial movable table (15) and which serves for the Y-axial drive, and a member (22) having an oblong opening extending in the X-axial

7     **0 017 144**     8

direction, whose width is greater than the outside diameter of said roller portion (23). (Fig. 2).

2. An apparatus for precisely moving a table comprising

rectilinear drive means respectively disposed and fixed on X- and Y-coordinate axes,

a movable member constructed on an X-axial movable table (7) and a Y-axial movable table (15), which tables are driven by the respective recilinear drive means, and

coupling means to couple said movable tables (7; 15) and said rectilinear drive means, characterized in that

the coupling means is constructed of two rollers (23, 23') whose respective rotary shafts are fastened to a part of said Y-axial movable table (15), and a rod (28) which extends in the X-axial direction and which is held between said two rollers (23, 23') with a backlash. (Fig. 4)

3. An apparatus for precisely moving a table according to claim 1 or 2, characterized in that

the motions of said X-axial and Y-axial movable tables (7; 15) are constrained by sliding guides (4, 5, 6; 12, 13, 14) respectively, wherein the Y-axial sliding guides (12, 13, 14) are disposed on said X-axial movable table (7).

4. An apparatus for precisely moving a table according to claim 3, characterized in that

a rolling guide (26) is disposed in a central part of said X-axial movable table (7) so as to uniformly relieve loads acting on the X-axial sliding guides (4, 5, 6). (Fig. 5)

**Patentansprüche**

1. Vorrichtung für die präzise Bewegung eines Tisches mit

geradlinigen Antriebseinrichtungen, die jeweils an X- und Y-Koordinatenaschen angeordnet und befestigt sind,

einem beweglichen Bauteil, das aus einem längs der X-Achse bewegbaren Tisch (7) und einem längs der Y-Achse bewegbaren Tisch (15) aufgebaut ist, die von der entsprechenden geradlinigen Antriebseinrichtung angetrieben werden, und

einer Kopplungseinrichtung zum Koppeln der bewegbaren Tische (7; 15) und der geradlinigen Atriebseinrichtungen, dadurch gekennzeichnet,

daß die Kopplungseinrichtung einen Rollenteil (23), dessen Drehachse an einem Teil des längs der Y-Achse bewegbaren Tisches (15) befestigt ist und der für den Y-Achsen-Antrieb dient, und ein Element (22) aufweist, das eine in Richtung der X-Achse verlaufende längliche Öffnung hat, deren Breit größer als der Außendurchmesser des Rollenteils (23) ist. (Fig. 2)

2. Vorrichtung für die präzise Bewegung eines Tisches mit

geradlinigen Antriebseinrichtungen, die jeweils an X- und Y-Koordinatenachsen angeordnet und befestigt sind,

einem beweglichen Bauteil, das aus einem längs der X-Achse bewegbaren Tisch (7) und einem längs der Y-Achse bewegbaren Tisch (15) aufgebaut ist, die von der entsprechenden geradlinigen Antriebseinrichtung angetrieben werden, und

einer Kopplungseinrichtung zum Koppeln der bewegbaren Tische (7; 15) und der geradlinigen Antriebseinrichtungen, dadurch gekennzeichnet,

daß die Kopplungseinrichtung aus zwei Rollen (23, 23'), deren jeweilige Drehachsen an einem Teil des längs der Y-Achse bewegbaren Tisches (15) befestigt sind, und einem Stab (28) aufgebaut ist, der in Richtung der X-Achse verläuft und mit einem Spielraum zwischen den zwei Rollen (23, 23') gehalten wird. (Fig. 4)

3. Vorrichtung für die präzise Bewegung eines Tisches nach Anspruch 1 oder 2, dadurch gekennzeichnet,

daß die Bewegungen der längs der X-Achse und längs der Y-Achse bewegbaren Tische (7; 15) jeweils durch Gleitführungen (4, 5, 6; 12, 13, 14) geführt werden, wobei die Gleitführungen (12, 13, 14) längs der Y-Achse auf dem längs der X-Achse bewegbaren Tisch (7) angeordnet sind.

4. Vorrichtung für die präzise Bewegung eines Tisches nach Anspruch 3, dadurch gekennzeichnet,

daß in einem Mittenteil des längs der X-Achse bewegbaren Tisches (7) eine Rollführung (26) angeordnet ist, um auf die Gleitführungen (4, 5, 6) längs der X-Achse wirkende Belastungen gleichmäßig zu mindern. (Fig. 5)

**Revendications**

1. Appareil pour déplacer de façon précise une table, comprenant

des moyens d'entraînement rectiligne disposés et fixés respectivement sur des axes de coordonnées X et Y,

un organe mobile constitué sous la forme d'une table (7) mobile suivant l'axe X et d'une table (15) mobile suivant l'axe Y, ces tables étant entraînes par les moyens d'entraînement rectiligne respectifs, et

des moyens d'accouplement servant à accoupler lesdites tables mobiles (7; 15) et lesdits dispositifs d'entraînement rectiligne, caractérisé en ce que lesdits moyens d'accouplement comprennent un élément de galet (23), dont l'arbre de rotation est fixé à une partie de ladite table (15) mobile suivant l'axe Y, et qui est utilisé pour l'entraînement suivant l'axe Y, et un organe (22) comportant une ouverture allongée s'étendant suivant la direction de l'axe X et dont la largeur est supérieure au diamètre extérieur dudit élément de galet (23) (figure 2).

2. Appareil pour déplacer de façon précise une table, comprenant

des moyens d'entraînement rectiligne disposés et fixés respectivement sur des axes de coordonnées X et Y,

un organe mobile constitué sous la forme d'une table (7) mobile suivant l'axe X et d'une table (15) mobile suivant l'axe Y, ces tables étant entraînées par les moyens d'entraînement rectilignes respectifs, et

des moyens d'accouplement servant à accoupler lesdites tables mobiles (7; 15) et lesdits dispositifs d'entraînement rectiligne, caractérisé en ce que les moyens d'accouplement sont constitués par deux galets (23, 23'), dont les arbres respectifs de rotation sont fixés à une partie de ladite table (15) mobile suivant l'axe Y, et une barre (28) qui s'étend suivant la direction de l'axe X et qui est maintenue avec jeu entre lesdits deux galets (23, 23') (figure 4)..

3. Appareil pour déplacer de façon précise une table selon la revendication 1 ou 2, caractérisé en ce que les déplacements desdites tables (7; 15) mobiles suivant l'axe X et suivant l'axe Y, sont contraints par des guides de glissement respectifs (4, 5, 6; 12, 13, 14), les guides (2, 13, 14) de glissement suivant l'axe Y étant disposés sur ladite table (7) mobile suivant l'axe X.

4. Appareil pour déplacer de façon précise une table selon la revendication 3, caractérisé en ce qu'un guide de roulement (26) est disposé dans une partie centrale de ladite table (7) mobile suivant l'axe X, de manière à réduire uniformément les contraintes agissant sur les guides (4, 5, 6) de glissement suivant l'axe X (figure 5).

0 017 144

## FIG. 1

## FIG. 2

# FIG. 3

$V_Y = f(\Delta Y)$

$V_Y$

$2\Delta\varepsilon$

$Y_3$      $Y_2$   $Y_1$    0    $\Delta Y$

# FIG. 4

Y

21

28

Y

21

23

23'

15

FIG. 5

3